# EUROPEAN PATENT APPLICATION

(11) **EP 3 179 520 A1**
(43) Date of publication of application: **14.06.2017**
(21) Application number: 15829537.8
(22) Date of filing: 29.07.2015
(51) Int. Cl.: H01L 31/049, B29C 65/40, H01L 31/048

(54) **METHOD FOR MANUFACTURING SOLAR CELL MODULE**

(30) Priority: 04.08.2014 JP 2014158411
(71) Applicant: Panasonic Intellectual Property Management Co., Ltd., Osaka-shi, Osaka 540-6207 (JP)
(72) Inventor: TAKENAKA, Masaharu, Osaka-shi Osaka 540-6207 (JP); NAKAMURA, Kei, Osaka-shi Osaka 540-6207 (JP)
(74) Representative: Müller-Boré & Partner Patentanwälte PartG mbB
(86) International application number: PCT/JP2015/003796
(87) International publication number: WO 2016/021151

(57) **Abstract**

A method for manufacturing a solar cell module (1) including: a front surface-side transparent protective member (10) having a curved shape; a back surface-side protective member (20) having a curved shape corresponding to the curved shape of the front surface-side transparent protective member (10); and a filler layer (30) which is disposed between the front surface-side transparent protective member (10) and the back surface-side protective member (20), and seals a solar cell (31) inside, the method comprising: preparing the front surface-side transparent protective member (10) having the curved shape and the back surface-side protective member (20) having the curved shape; and manufacturing the solar cell module (1) by disposing the solar cell (31) and the filler layer (30) between the front surface-side transparent protective member (10) and the back surface-side protective member (20), and by pressing the front surface-side transparent protective member (10), the back surface-side protective member (20), the solar cell (31), and the filler layer (30).

## Description

### TECHNICAL FIELD

The present disclosure relates to a method for manufacturing a solar cell module.

### BACKGROUND ART

Solar cells are installed in houses, and electrical power generated by the solar cells is used domestically or sold to power companies. Although the solar cells have been previously installed mainly on flat roofs, installing the solar cells in places other than the roofs is being considered. Patent Literature (PLT) 1 (Japanese Unexamined Patent Application Publication No. H05-5344) discloses that flat panel solar cells are provided on a transparent glass roofing material having a curved surface.

### Citation List

### Patent Literature

PTL 1: Japanese Unexamined Patent Application Publication No. H05-5344

### SUMMARY OF THE INVENTION

### TECHNICAL PROBLEM

When solar cells are mounted on a curved surface, a solar cell module which fits a curved shape is demanded. A solar cell module is typically obtained by disposing a filler layer which includes, for example, resin and seals a solar cell inside, between a front surface-side transparent protective member including, for example, a glass plate and a back surface-side protective member including, for example, a resin sheet which is flexible.

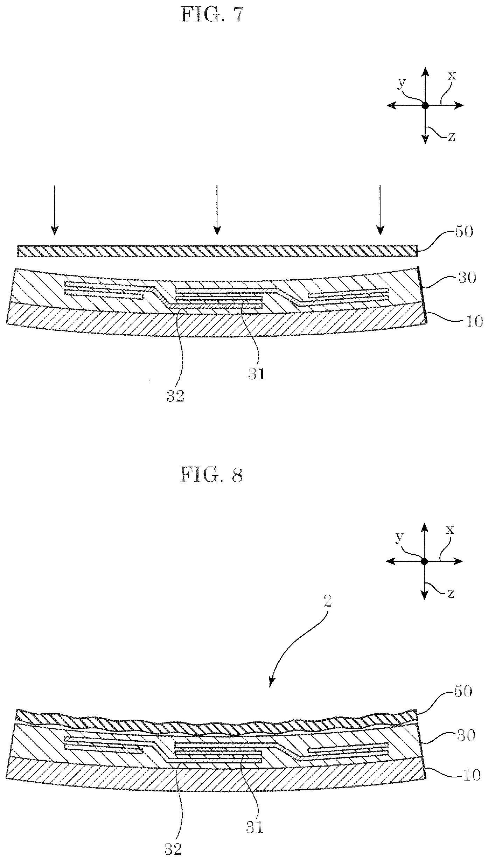

FIG. 7 is a schematic cross-sectional view illustrating a conventional method for manufacturing a solar cell module having a curved shape. As illustrated by FIG. 7, filler layer 30 which seals solar cells 31 inside is mounted on front surface-side transparent protective member 10 having a curved shape, and after plate-like back surface-side protective member 50 which is flexible is mounted on filler layer 30, back surface-side protective member 50, filler layer 30, and front surface-side transparent protective member 10 are pressed to manufacture a solar cell module. Each solar cell 31 is electrically connected via wiring member 32 in filler layer 30.

FIG. 8 is a schematic cross-sectional view illustrating solar cell module 2 resulting from the pressing performed in the state illustrated by FIG. 7. As illustrated by FIG. 8, with the conventional method, back surface-side protective member 50 does not fit a curved surface, and many creases are formed in back surface-side protective member 50.

An object of the present disclosure is to provide a method for manufacturing a solar cell module having a curved shape, the method making it possible to prevent creases from forming in a back surface-side protective member.

### SOLUTION TO PROBLEM

A method for manufacturing a solar cell module according to one aspect of the present invention is a method for manufacturing a solar cell module including: a front surface-side transparent protective member having a curved shape; a back surface-side protective member having a curved shape corresponding to the curved shape of the front surface-side transparent protective member; and a filler layer which is disposed between the front surface-side transparent protective member and the back surface-side protective member, and seals a solar cell inside, the method comprising: preparing the front surface-side transparent protective member having the curved shape and the back surface-side protective member having the curved shape; and manufacturing the solar cell module by disposing the solar cell and the filler layer between the front surface-side transparent protective member and the back surface-side protective member, and by pressing the front surface-side transparent protective member, the back surface-side protective member, the solar cell, and the filler layer.

### ADVANTAGEOUS EFFECT OF INVENTION

With the aspect of the present invention, the method for manufacturing the solar cell module having a curved shape makes it possible to prevent creases from forming in the back surface-side protective member.

### BRIEF DESCRIPTION OF DRAWINGS

FIG. 1 is a schematic cross-sectional view illustrating a solar cell module according to an embodiment.
FIG. 2 is a schematic perspective view illustrating the solar cell module according to the embodiment.
FIG. 3 is a flow chart illustrating steps for manufacturing the solar cell module according to the embodiment.
FIG. 4 is a schematic cross-sectional view illustrating a step for manufacturing the solar cell module by mounting a back surface-side protective member having a curved shape on a filler layer mounted on a front surface-side transparent protective member having a curved shape, and pressing the back surface-side protective member, the filler layer, and the front surface-side protective member.
FIG. 5 is a schematic cross-sectional view illustrating a state where a back surface-side protective member having a plate shape is mounted on a mold having a curved shape.
FIG. 6 is a schematic cross-sectional view illustrating a state where the back surface-side protective member is heated on the mold to give the back surface-side protective member a curved shape.
FIG. 7 is a schematic cross-sectional view illustrating a conventional method for manufacturing a solar cell module.
FIG. 8 is a schematic cross-sectional view illustrating the solar cell module manufactured by the convention method illustrated by FIG. 7.

### DESCRIPTION OF EXEMPLARY EMBODIMENT

The following describes a method for manufacturing a solar cell module according to an embodiment, with reference to the drawings. However, the following embodiment is merely an example and does not limit the scope of the present disclosure. The numerical values, shapes, materials, structural elements, the arrangement and connection of the structural elements, etc. shown in the following embodiment are mere examples, and therefore do not limit the scope of the present disclosure. Structural elements having essentially the same functions may share the same reference numbers in the figures.

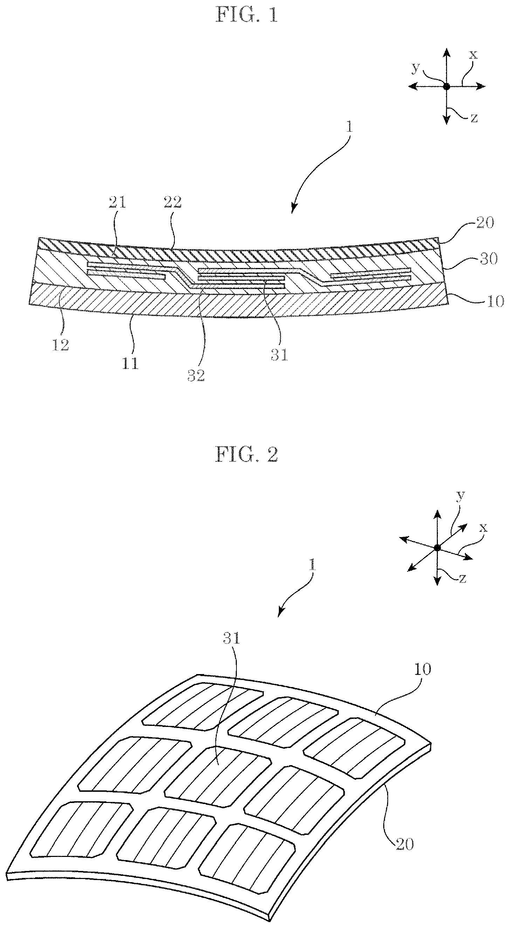

FIG. 1 is a schematic cross-sectional view illustrating a solar cell module according to the embodiment. As illustrated by FIG. 1, solar cell module 1 according to the embodiment includes: front surface-side transparent protective member 10; back surface-side protective member 20; and filler layer 30 which is disposed between front surface-side transparent protective member 10 and back surface-side protective member 20, and seals solar cells 31 inside.

First principal surface 11 on a front surface side of front surface-side protective member 10 and second principal surface 12 on a back surface side of front surface-side protective member 10 each have a curved shape bulging toward the front surface side. In addition, first principal surface 21 on a front surface side of back surface-side protective member 20 and second principal surface 22 on a bask surface side of back surface-side protective member 20 each also have a curved shape bulging toward the front surface side. The curved shape of back surface-side protective member 20 corresponds to the curved shape of front surface-side protective member 10. Each solar cell 31 is electrically connected via wiring member 32 in filler layer 30.

FIG. 2 is a schematic perspective view illustrating the solar cell module according to the embodiment illustrated by FIG. 1. As illustrated by FIG. 2, the curved shape of front surface-side protective member 10 and the curved shape of back surface-side protective member 20 bulge toward the front surface side and curve in an x direction and a y direction perpendicular to the x direction. Accordingly, the curved shape of front surface-side protective member 10 and the curved shape of back surface-side protective member 20 are a three-dimensionally curved shape.

Front surface side transparent protective member 10 may include, for example, a glass plate or a transparent resin plate such as an acryl plate and a polycarbonate plate. Filler layer 30 may include a crosslinking resin such as an ethylene-vinyl acetate (EVA) copolymer or a non-crosslinking resin such as polyolefin.

In the embodiment, back surface-side protective member 20 includes a sheet material which is flexible. Examples of the sheet material which is flexible include a resin sheet material such as polyvinylidene fluoride (PVF), polyethylene terephthalate (PET), and polytetrafluoroethylene (PTFE). In addition, the sheet material which is flexible may be formed by laminating metal foils such as aluminum foils. A thickness of back surface-side protective member 20 is preferably in a range from 50 µm to 350 µm, and more preferably in a range from 130 µm to 250 µm.

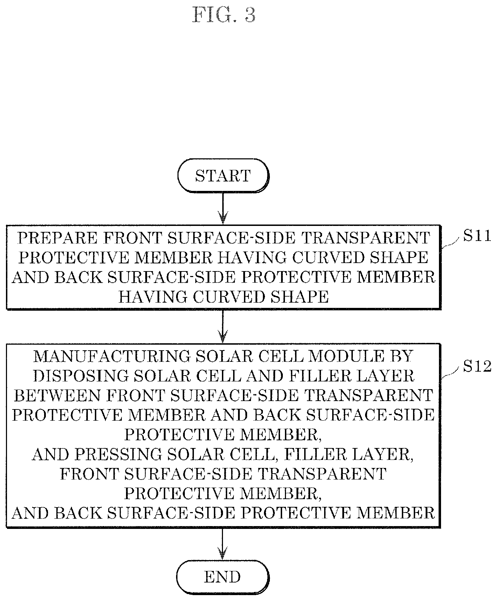

FIG. 3 is a flow chart illustrating steps for manufacturing the solar cell module according to the embodiment.

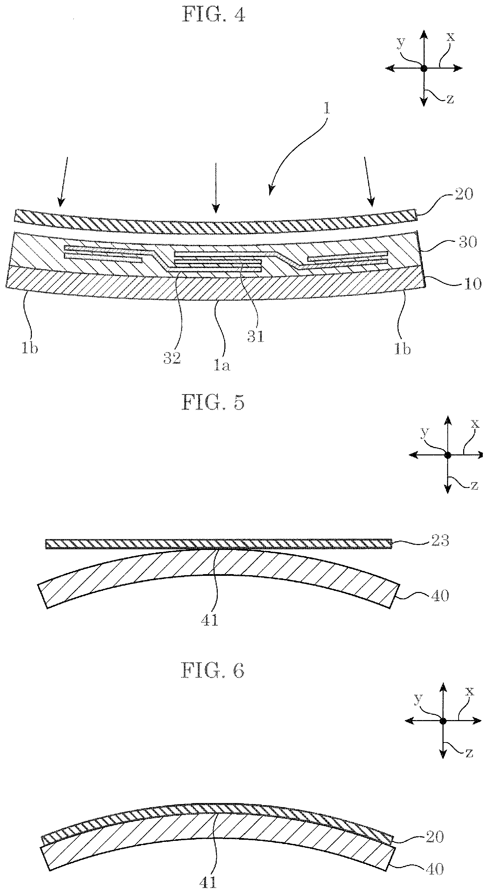

FIG. 4 is a schematic cross-sectional view for illustrating a step for manufacturing the solar cell module according to the embodiment.

First, front surface-side transparent protective member 10 having a curved shape and back surface-side protective member 20 having a curved shape are prepared (Step S11).

Specifically, front surface-side transparent protective member 10 having the curved shape is prepared. Front surface-side transparent protective member 10 having the curved shape can be produced by bending by heat, cutting, and the like a glass plate or a resin plate having a plate shape. In addition, front surface-side transparent protective member 10 having the curved shape may be produced by pressing front surface-side transparent protection member 10 using a metal mold or the like. Back surface-side transparent protective member 20 having the curved shape is also prepared.

Next, solar cell module 1 is manufactured by disposing solar cells 31 and filler layer 30 between front surface-side transparent protective member 10 and back surface-side protective member 20, and pressing front surface-side transparent protective member 10, back surface-side protective member 20, solar cells 31, and filler layer 30 (Step S12).

Specifically, a crosslinking resin or non-crosslinking resin sheet which is to be filler layer 30 is laminated on front surface-side transparent protective member 10, and solar cells 31 electrically connected via wiring member 32 are disposed on the crosslinking resin or non-crosslinking resin sheet. Another crosslinking resin or non-crosslinking resin sheet which is to be filler layer 30 is disposed on solar cells 31.

Next, as illustrated by FIG. 4, back surface-side protective member 20 having the curved shape is laminated on filler layer 30. Subsequently, this laminated body is pressed by heat. Consequently, it is possible to manufacture solar cell module 1 in which front surface-side transparent protective member 10, filler layer 30, and back surface-side protective member 20 are laminated.

In the embodiment, unlike the conventional method illustrated with reference to FIGS. 7 and 8, back surface-side protective member 20 to which the curved shape is previously given is used instead of back surface-side protective member 50 having a plate shape. For this reason, it is possible to prevent creases from forming in back surface-side protective member 20. Accordingly, with the embodiment, it is possible to improve an appearance design of solar cell module 1.

A heating temperature for pressing may be a temperature at which back surface-side protective member 20 is not deteriorated by heat. Specifically, the temperature is preferably in a range from 100 °C to 240 °C, and more preferably in a range from 120 °C to 180 °C. Moreover, solar cell module 1 may be heated to cause peripheral portion 1b of solar cell module 1 in a plan view (x direction and y direction) to have a higher temperature than central portion 1a of solar cell module 1 in the plan view. The difference in temperature between peripheral portion 1b and central portion 1a is preferably in a range from 20 °C to 50 °C, and more preferably in a range from 40 °C to 50 °C. Setting such a difference in temperature allows peripheral portion 1b to actively expand and contract by heat to easily fit the curved shape, which makes it possible to easily perform processing.

FIGS. 5 and 6 each are a schematic cross-sectional view for illustrating an exemplary step for giving a curved shape to a back surface protective member having a plate shape. FIG. 5 illustrates a state where back surface-side protective member 23 having a plate shape is mounted on a mold having a curved shape. Top surface 41 of mold 40 has the curved shape to be given to back surface-side protective member 23. Suction ports which are not illustrated are formed in top surface 41. Back surface-side protective member 23 is held above top surface 41 of mold 40 by being sucked through the suction ports. In the state illustrated by FIG. 5, back surface-side protective member 23 is heated to fit a shape of top surface 41 of mold 40. Specifically, back surface-side protective member 23 is heated to soften, and an own weight of back surface-side protective member 23 and the suction through the suction ports formed in top surface 41 cause back surface-side protective member 23 to stick to top surface 41 of mold 40. With this, back surface-side protective member 23 is fitted to the shape of top surface 41 of mold 40.

FIG. 6 is a schematic cross-sectional view illustrating a state where the back surface-side protective member is given the curved shape. As illustrated by FIG. 6, the curved shape fitted to the shape of top surface 41 of mold 40 is given to back surface-side protective member 20.

As illustrated with reference to FIG. 4, solar cell module 1 according to the embodiment can be manufactured using back surface-side protective member 20 having the curved shape thus obtained. However, a method for giving a back surface-side protective member a curved shape is not limited to the method described in the embodiment.

Although the exemplary three-dimensionally curved shape has been illustrated as the curved shape in the embodiment, the present disclosure is not limited to this. For example, a two-dimensionally curved shape which curves only in the x direction or the y direction.

Moreover, although the exemplary curved shape (convex shape) bulging toward the front surface side of solar cell module 1 has been illustrated as the curved shape, the present disclosure is not limited to this. For example, a curved shape (concave shape) bulging toward the back surface side of solar cell module 1 may be used.

Although the method for manufacturing the solar cell module has been described above based on the aforementioned embodiment, the present invention is not limited to the aforementioned embodiment. The present invention includes a mode obtained by making various modifications conceived by a person skilled in the art to embodiments and a mode achieved by any combinations of structural components and functions in the embodiments as long as not departing from the purport of the present invention.

### INDUSTRIAL APPLICABILITY

### REFERENCE MARKS IN THE DRAWINGS

- 1, 2: solar cell module
- 1a: peripheral portion of solar cell module in plan view
- 1b: central portion of solar cell module in plan view
- 10: front surface-side protective member
- 11: first principal surface
- 12: second principal surface
- 20: back surface-side protective member having curved shape
- 21: first principal surface
- 22: second principal surface
- 23: back surface-side protective member having plate shape
- 30: filler layer
- 31: solar cell
- 32: wiring member
- 40: mold
- 41: top surface
- 50: back surface-side protective member

## Claims

1. A method for manufacturing a solar cell module including: a front surface-side transparent protective member having a curved shape; a back surface-side protective member having a curved shape corresponding to the curved shape of the front surface-side transparent protective member; and a filler layer which is disposed between the front surface-side transparent protective member and the back surface-side protective member, and seals a solar cell inside, the method comprising:
preparing the front surface-side transparent protective member having the curved shape and the back surface-side protective member having the curved shape; and
manufacturing the solar cell module by disposing the solar cell and the filler layer between the front surface-side transparent protective member and the back surface-side protective member, and by pressing the front surface-side transparent protective member, the back surface-side protective member, the solar cell, and the filler layer.

2. The method according to claim 1,
wherein the back surface-side protective member includes a sheet material which is flexible.

3. The method according to claim 1 or claim 2,
wherein when the pressing is performed, the solar cell module is heated to cause a peripheral portion of the solar cell module in a plan view to have a higher temperature than a central portion of the solar cell module in the plan view.

4. The method according to any one of claims 1 to 3,
wherein each of the curved shapes is a three-dimensionally curved shape.
